# EUROPEAN PATENT APPLICATION

(11) **EP 3 933 894 A1**
(43) Date of publication of application: **05.01.2022**
(21) Application number: 20885826.6
(22) Date of filing: 27.07.2020
(51) Int. Cl.: H01L 21/308, H01L 21/762, H01L 21/8239, H01L 27/105

(54) **MEMORY AND FORMING METHOD THEREFOR**

(30) Priority: 08.11.2019 CN 201911087070
(71) Applicant: Changxin Memory Technologies, Inc., Anhui 230000 (CN)
(72) Inventor: ZHANG, Qiang, Hefei, Anhui 230000 (CN); YING, Zhan, Hefei, Anhui 230000 (CN)
(74) Representative: Lavoix
(86) International application number: PCT/CN2020/104965
(87) International publication number: WO 2021/088431

(57) **Abstract**

A memory and a formation method thereof are provided. The formation method includes: providing a substrate; forming a first mask layer on a surface of the substrate, a plurality of strip-shaped patterns arranged in parallel being formed in the first mask layer; forming a second mask layer on the first mask layer, a plurality of first patterns and a plurality of second patterns being formed in the second mask layer, the plurality of first patterns being arranged in an array and being overlapped with the strip-shaped patterns, the plurality of second patterns covering ends of a part of the strip-shaped patterns; and performing etching layer by layer into the substrate by using the first mask layer and the second mask layer as masks to transfer the strip-shaped patterns, the first patterns and the second patterns into the substrate to form a plurality of discrete active areas arranged in an array and division trenches corresponding to the first patterns and the second patterns. The reliability of the memory formed by the above method is improved

## Description

### CROSS-REFERENCE TO RELATED APPLICATIONS

This application claims priority to Chinese Patent Application No. 201911087070.4, titled "MEMORY AND FORMATION METHOD THEREOF" and filed on November 8, 2019, the entire contents of which are incorporated herein by reference.

### TECHNICAL FIELD

The present disclosure relates to the field of memory technologies, and more particularly, to a memory and a formation method thereof.

### BACKGROUND

A memory includes a plurality of memory cells arranged in an array, and each of the memory cells is formed on an active area (AA). In the process of forming the memory in a prior art, generally it is required to etch a substrate to form the active areas arranged in an array.

As a memory capacity of the memory increases, a memory density increases, and a line width of the active area gradually shrinks. When a plurality of mask patterns arranged in an array are formed on a surface of the substrate to serve as a mask of the active area, a self-aligned double patterning (SADP) process is required to form an AA mask with a smaller line width pattern to form a strip-shaped AA. Next, a shallow trench isolation (STI) mask is formed on the AA mask to cut off the strip-shaped AA to form the active areas arranged in an array.

When the SADP process is employed to form the active area of an array area of the memory, a size of the formed active area is very small because the size of the AA mask is small, and thus an edge of an active area array may have problems such as collapse and stress, which may have a negative effect on product yield.

How to improve the edge problem of the active area array of the memory is a problem to be solved urgently at present.

### SUMMARY

A technical problem to be solved by the present disclosure is to provide a memory and a formation method thereof which can improve an edge problem of an active area array of a memory.

To solve the above problem, the present disclosure provides a formation method of a memory. The method includes: providing a substrate including an array area; forming a first mask layer on a surface of the substrate, wherein a plurality of strip-shaped patterns arranged in parallel are formed in the first mask layer to form, in the array area of the substrate, a plurality of strip-shaped continuous active areas arranged in parallel; forming a second mask layer on the first mask layer, wherein a plurality of first patterns and a plurality of second patterns are formed in the second mask layer, the plurality of first patterns are arranged in an array and are overlapped with the strip-shaped patterns to form division trenches in the substrate to divide the continuous active areas into a plurality of separate discrete active areas arranged in an array, wherein the plurality of second patterns cover ends of a part of the strip-shaped patterns to remove secondary active areas positioned at ends of a part of continuous active areas, wherein the secondary active areas are formed after the continuous active areas are divided by the first patterns and are less than the discrete active areas in length; and performing etching layer by layer into the substrate by using the first mask layer and the second mask layer as masks to transfer the strip-shaped patterns, the first patterns and the second patterns into the substrate to form the plurality of discrete active areas arranged in an array and the division trenches corresponding to the first patterns and the second patterns.

In some embodiments, the strip-shaped patterns are formed by using an SADP method.

In some embodiments, the plurality of first patterns include central first patterns and peripheral first patterns, wherein the peripheral first patterns are outermost first pattern, and the central first patterns are positioned at an inner side of the peripheral first pattern. The peripheral first pattern extends outward along a length direction of the strip-shaped pattern, such that a size of the peripheral first pattern is greater than that of the central first pattern.

In some embodiments, a size of an outermost division trench is greater than sizes of division trenches in other positions.

In some embodiments, the substrate further includes a peripheral area encircling the array area, and in the second mask layer there is further formed a third pattern positioned on the peripheral area of the substrate and encircling all the strip-shaped patterns. The third pattern is configured for forming, in the peripheral area of the substrate, a peripheral trench encircling the array area.

In some embodiments, a sidewall of the peripheral trench facing toward a side of the array area is a curved surface.

In some embodiments, the formation method further includes: filling an insulating material in the division trench and the peripheral trench to form a shallow trench isolation structure.

The technical solution of the present disclosure also provides a memory, including a substrate, the substrate including an array area. A plurality of discrete active areas arranged in an array are formed in the array area. The discrete active areas are isolated by the shallow trench isolation structure, wherein sizes of at least a part of the outermost shallow trench isolation structures in a length direction of the discrete active area are greater than those of shallow trench isolation structures in other positions in the length direction of the discrete active area.

In some embodiments, the substrate further includes a peripheral area encircling the array area, a peripheral shallow trench isolation structure is formed in the peripheral area of the substrate, and the peripheral shallow trench isolation structure encircles the array area.

In some embodiments, the discrete active area is isolated from the peripheral area by the shallow trench isolation structure.

In some embodiments, a sidewall of the peripheral shallow trench isolation structure facing toward a side of the array area is a curved surface.

In some embodiments, there is a certain spacing between the peripheral shallow trench isolation structure and the array area.

In some embodiments, in all the shallow trench isolation structures, the size of the outermost shallow trench isolation structure is greater than those of the shallow trench isolation structures in other positions.

According to the formation method of a memory provided by the present disclosure, in the process of dividing the continuous active areas, the smaller-sized secondary active area at the edge of the discrete active area array is removed. Therefore, problems such as collapse due to the smaller-sized secondary active area present at the edge of the active area array may be prevented, and thus the reliability of the memory can be improved.

Further, a peripheral shallow trench isolation structure for dividing the continuous active area has a larger size, which can avoid an etching load effect in the process of forming a trench by etching. Therefore, a photoetching process window is reduced, and a patterning accuracy in the formation of the shallow trench isolation structure is enhanced, and thus performance of the memory is further improved.

### BRIEF DESCRIPTION OF THE DRAWINGS

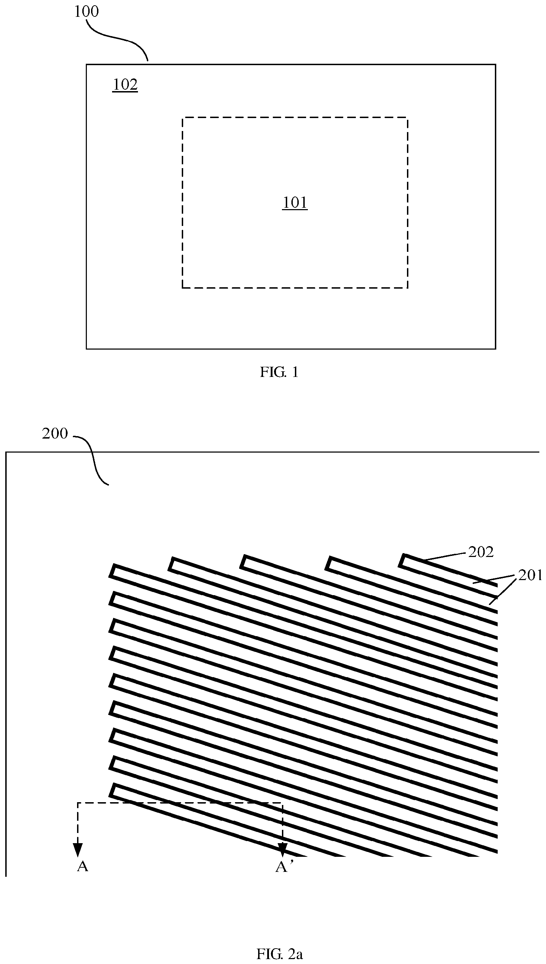

FIG. 1 to FIG. 8 are schematic structural diagrams showing formation processes of a memory according to some embodiments.

### DETAILED DESCRIPTION

Embodiments of a memory and a formation method thereof provided by the present disclosure are described below in detail with reference to the accompanying drawings.

With reference to FIG. 1, a schematic structural diagram showing formation processes of the memory according to an embodiment of the present disclosure is illustrated.

With reference to FIG. 1, a substrate 100 is provided. The substrate 100 includes an array area 101 and a peripheral area 102 encircling the array area 101.

In the array area 101 there is an active area array for forming a memory, and in the peripheral area 102 there is a peripheral device (such as a logic control circuit) for forming the memory.

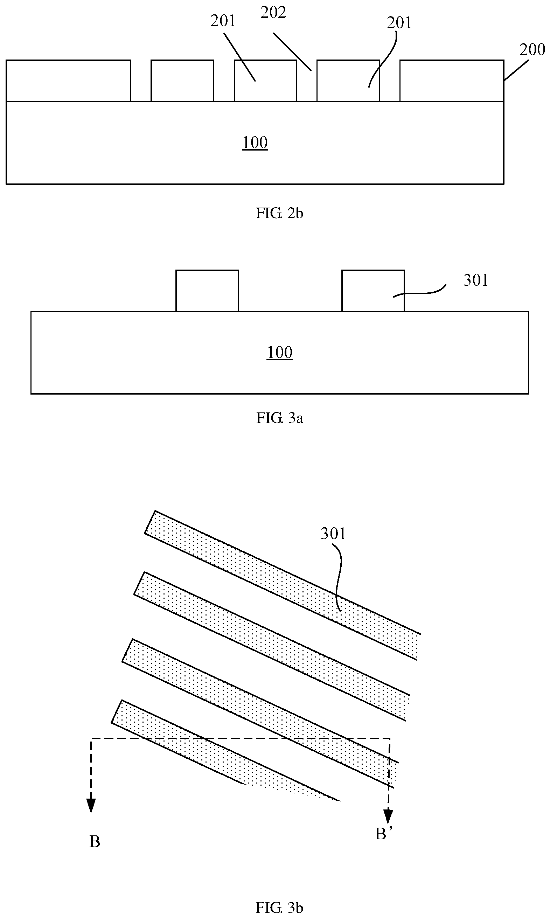

With reference to FIG. 2a and FIG. 2b, a first mask layer 200 is formed on a surface of the substrate 100. A plurality of strip-shaped patterns 201 arranged in parallel are formed in the first mask layer 200 and include a strip-shaped pattern 201a and a strip-shaped pattern 201b. The strip-shaped patterns 201 are covered patterns and are configured for forming, in the array area 101 of the substrate 100, a plurality of discrete and strip-shaped continuous active areas arranged in parallel. Between the strip-shaped patterns 201 there is an opening 202, configured for separating the strip-shaped patterns 201. FIG. 2a is a schematic top view, and FIG. 2b is a schematic cross-sectional view along a secant line AA' in FIG. 2a. Before the first mask layer 200 is formed, a buffer layer, a hard mask layer or the like may also be formed on the surface of the substrate 100 to improve the pattern-transfer accuracy in subsequent etching processes.

The strip-shaped pattern is formed by the SADP method. In one embodiment, with reference to FIG. 3a to FIG. 3f, schematic structural diagrams showing a method for forming the first mask layer according to an embodiment of the present disclosure are illustrated.

With reference to FIG. 3a and FIG. 3b, a mask pattern 301 is formed on the surface of the substrate 100. FIG. 3a is a schematic top view of the mask pattern 301, and FIG. 3b is a schematic cross-sectional view along the secant line BB' in FIG. 3a. The mask pattern 301 has strip-shaped patterns arranged in parallel. In this embodiment, the mask pattern 301 is arranged obliquely to increase an arrangement density of the discrete active areas formed subsequently. In other embodiments, the mask pattern 301 may also be arranged horizontally or vertically.

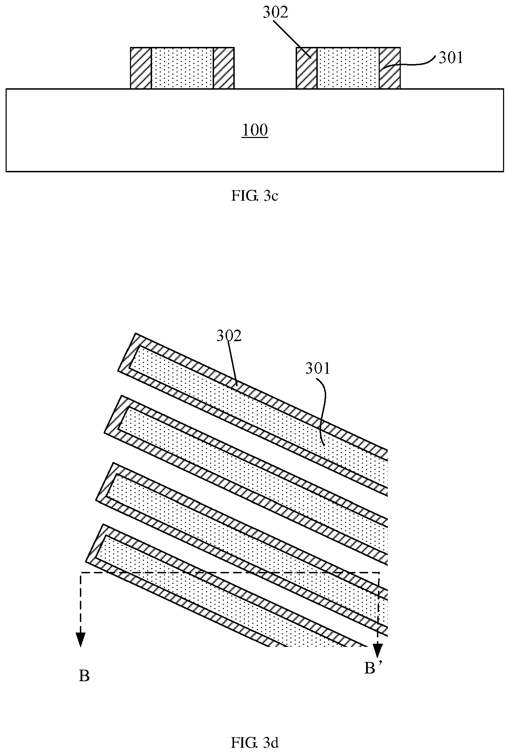

With reference to FIG. 3c and FIG. 3d, a sidewall 302 is formed on a sidewall of the mask pattern 301, and the sidewall 302 encircles the sidewall of the mask pattern 301.

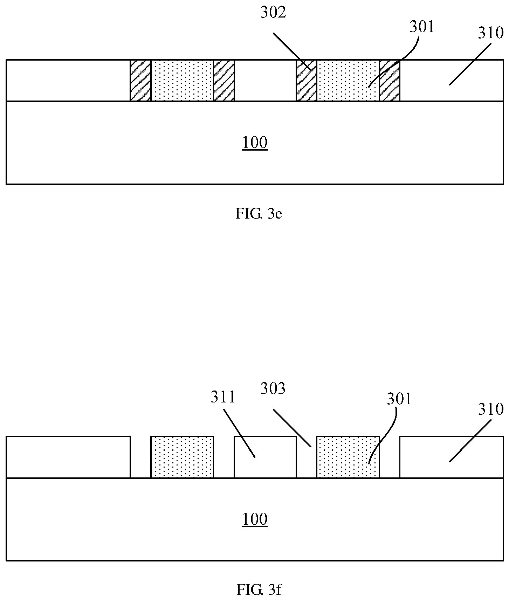

With reference to FIG. 3e, a first mask material 310 is filled and formed on the surface of the substrate 100, and a surface of the first mask material 310 is flush with a surface of the mask pattern 301.

With reference to FIG. 3f, the sidewall 302 is removed to form an opening 303 (corresponding to the opening 202 in FIG. 2). The mask pattern 301 (corresponding to the strip-shaped pattern 201a in FIG. 2) and a mask pattern 311 (corresponding to the strip-shaped pattern 202b in FIG. 2) on two sides of the opening are used as strip-shaped patterns to define a width and a length of the continuous active area to be formed in the substrate subsequently. Through the above SADP method, a spacing between adjacent strip-shaped patterns may be reduced, such that a density of the strip-shaped patterns can be increased.

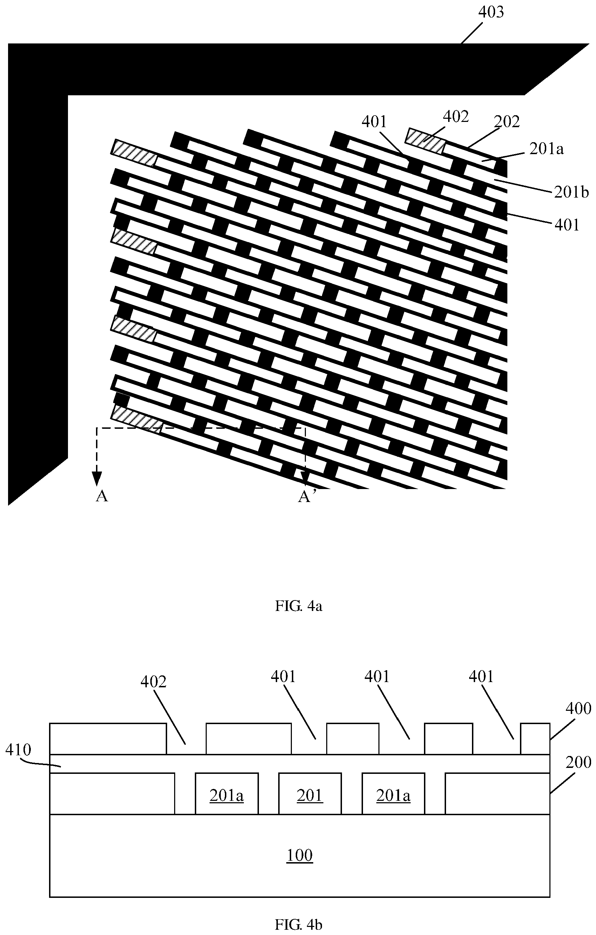

With reference to FIG. 4a and FIG. 4b, a second mask layer 400 is formed on the first mask layer 200, a plurality of first patterns 401 and a plurality of second patterns 402 are formed in the second mask layer 400. The plurality of first patterns 401 are arranged in an array and are overlapped with the strip-shaped patterns 201a and 201b to form division trenches in the substrate 100 so that the continuous active areas are divided into a plurality of discrete active areas arranged in an array. The plurality of second patterns 402 cover ends of a part of the strip-shaped pattern 201a to remove secondary active areas positioned at ends of a part of continuous active areas, wherein the secondary active areas are formed after the continuous active areas are divided by the first patterns 401 and are less than the discrete active areas in length.

In FIG. 4a, only the first patterns 401 and the second patterns 402 in the second mask layer 400 are shown. The first patterns 401 and the second patterns 402 are both opening patterns, and the other areas are covered patterns (not shown in the figure). FIG. 4b is a schematic cross-sectional view along a secant line AA' in FIG. 4a.

Before the second mask layer 400 is formed, it is formed a filling layer 410 that fills up the opening 202 in the first mask layer 200 and has a planar surface, and the second mask layer 400 is formed on the planar surface of the filling layer 410. A material of the filling layer 410 may be an organic anti-reflection layer, silicon oxide or the like.

The first pattern 401 is an opening pattern, and the strip-shaped patterns 201a and 201b are covered patterns. Therefore, after the substrate 100 is etched along the first pattern 401, a division trench is formed by cutting off the continuous active area correspondingly formed by the strip-shaped patterns 201a and 201b in the substrate 100.

To increase the memory density, the first patterns 401 are arranged in staggered rows, such that the discrete active areas formed after division are arranged in staggered rows to increase the number of discrete active areas. This may cause the active areas positioned at ends to be less than the normal discrete active areas in length after a part of continuous active areas are divided, and these active areas with shorter length are referred to as secondary active areas. The secondary active area is unable to form a complete memory cell, and is prone to problems such as collapse. A formation position of the secondary active area generally corresponds to an end of the strip-shaped pattern 201a encircled by the opening 202.

In this embodiment, in the second mask layer 400 there is further formed a second pattern 402 which is also an opening pattern. The second pattern 402, covering a position of the end of the strip-shaped pattern 201 corresponding to the secondary active area, is configured for removing the secondary active area, to prevent the problem of collapse of the secondary active area, thereby improving the edge problem of the active area array.

In this embodiment, an end of the strip-shaped pattern 201b at an outer side of the opening 202 is connected to the first mask layer on the peripheral area of the substrate 100. For this reason, an end of the continuous active area correspondingly formed in the substrate 100 is connected to the peripheral area of the substrate 100, and the problems such as collapse generally do not occur even if the size of the continuous active area is less than that of the discrete active area. Therefore, the second pattern 402 generally is formed above the end of the strip-shaped pattern 201 partially encircled by the opening 202.

In other embodiments, in the second mask layer 400 there is likely formed a pattern cutting off the strip-shaped pattern 201b from the peripheral area, which may cause a consequence that the secondary active area may likely be formed at an end of a formed continuous active area corresponding to the continuous active area 201b after this continuous active area is divided. Correspondingly, the second pattern 402 is also required to be formed on the ends of a part of the strip-shaped patterns 201b.

In this embodiment, in the second mask layer 400 there is also formed a third pattern 403 positioned above the peripheral area 102 and encircling all the strip-shaped patterns 201a and 201b. The third pattern 403 is configured for forming, in the peripheral area 102 of the substrate 100, a peripheral trench encircling the array area 101. The third pattern 403 is also an opening pattern.

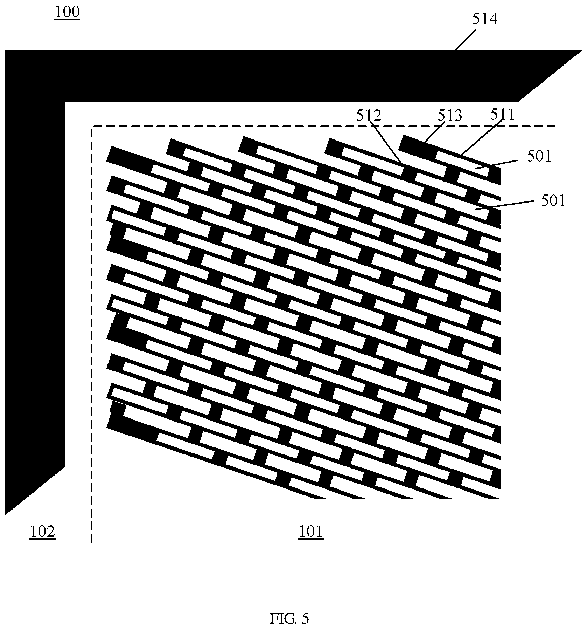

With reference to FIG. 5, it is etched layer by layer into the substrate 100 by using the first mask layer 200 and the second mask layer 400 as masks to transfer the strip-shaped patterns 201a and 201b, the first pattern 401 and the second pattern 402 into the substrate 100 to form a plurality of discrete active areas 501 arranged in an array. Adjacent discrete active areas in the same straight line and adjacent discrete active areas in different straight lines are separated by division trenches. An insulating material is filled in the division trenches to form a shallow trench isolation structure.

The first pattern 401 corresponds to the shallow trench isolation structure 512, the second pattern 402 corresponds to the shallow trench isolation structure 513, and the opening 202 corresponds to the shallow trench isolation structure 511.

Furthermore, in the peripheral area of the substrate 100 there is also formed a peripheral shallow trench isolation structure 514 which corresponds to the third pattern 403 (referring to FIG. 4a).

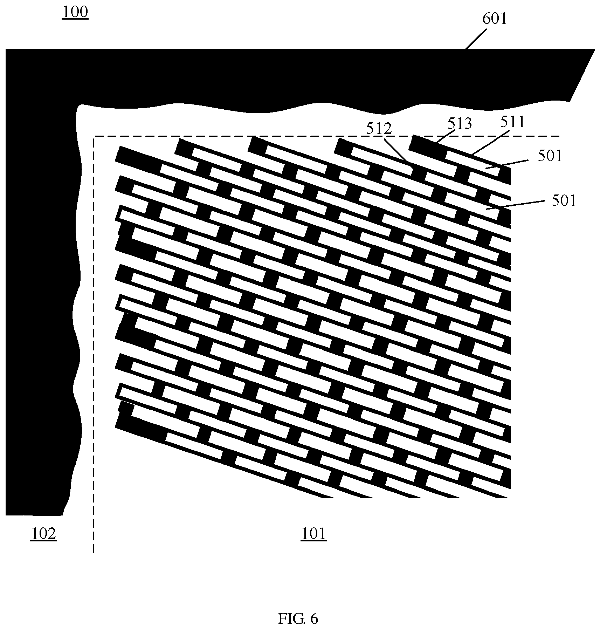

In another embodiment, a side of the third pattern 403 facing toward the array area is a curve, such that a sidewall of the formed peripheral shallow trench isolation structure 601 (referring to FIG. 6) facing toward the array area is a curved surface. In this way, the total length of the sidewalls can be increased, the stability can be enhanced, the stress generated by the peripheral shallow trench isolation structure 514 can be further relieved, and the stress effects on the discrete active area 501 at the edge of the array area can be reduced.

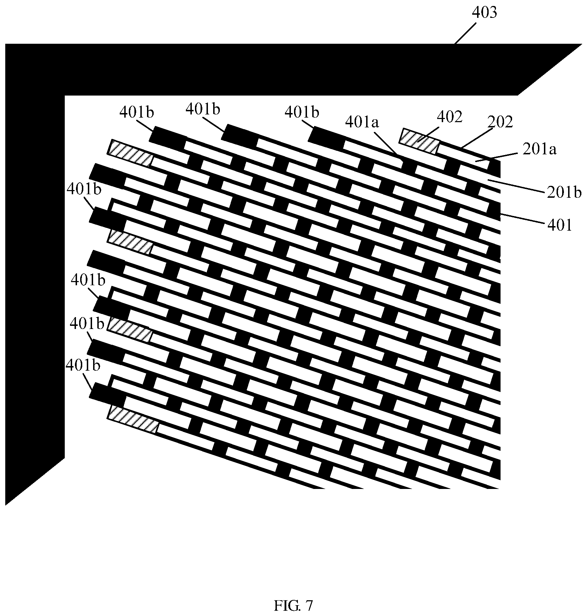

With reference to FIG. 7, it is illustrated a schematic diagram after the formation of the second mask layer 400 in another embodiment of the present disclosure.

The first patterns in the second mask layer include central first patterns 401a and peripheral first patterns 401b, wherein the peripheral first pattern 401b is an outermost first pattern, and the central first pattern 401a is positioned at an inner side of the peripheral first pattern 401b. The peripheral first pattern 401b extends outward along a length direction of the strip-shaped patterns 201a and 201b, such that the size of the peripheral first pattern 401b is greater than that of the central first pattern 401a. The peripheral first pattern has a lower pattern density on the outer side, and thus in the etching process, an etching load effect caused by different pattern densities is prone to causing a transfer distortion of the outermost first pattern. Therefore, in this embodiment, by ensuing the size of the peripheral first pattern 401b to be greater than that of the central first pattern 401a, the etching load effect can be overcome, a photoetching process window can be increased, and a pattern-transfer accuracy can be improved.

In the embodiment as shown in FIG. 7, the peripheral pattern 401a and the second pattern 402 correspond to the outermost division trench formed in the array area of the substrate, and the outermost division trench is larger in size than division trenches in other positions.

In other embodiments, in the second mask layer 400 there also may be not formed the second pattern 402, and only the central first pattern 401a and the peripheral first pattern 401b are included, to correspondingly form the division trenches for dividing the continuous active areas.

In the foregoing embodiments, the substrate is etched after the formation of a plurality of mask layers having different patterns. In this way, an active area array can be directly formed in the substrate.

In the embodiments of the present disclosure, there is also provided another method for forming a memory.

The method for forming a memory includes following steps: providing a substrate, wherein the substrate includes an array area and a peripheral area encircling the array area; forming, in the array area of the substrate, a plurality of discrete and strip-shaped continuous active areas arranged in parallel; forming, in the array area of the substrate, a plurality of division trenches arranged in an array to divide the continuous active areas into a plurality of discrete active areas arranged in an array; and removing secondary active areas positioned at ends of a part of continuous active areas when dividing each of the continuous active areas, wherein the secondary active areas are formed after the continuous active areas are divided and are less than the discrete active areas in length.

The first mask layer 200 having the strip-shaped patterns 201a and 201b as shown in FIG. 2a may be formed on the surface of the substrate, and then the substrate is etched using the first mask layer 200 as a mask to form the strip-shaped continuous active areas in the substrate.

Next, after the first mask layer 200 is removed, the second mask layer 400 having the first pattern 401 and the second pattern 402 as shown in FIG. 4a and FIG. 4b is formed on the substrate, and then the substrate is etched using the second mask layer 400 as a mask. Next, by transferring the first pattern 401 and the second pattern 402 into the substrate, the continuous active area in the substrate is divided into a plurality of discrete active areas. Because the second pattern 402 is formed in the second mask layer 400, when each of the continuous active areas is divided, the secondary active areas, which are positioned at the ends of a part of continuous active areas and are less than the discrete active areas in length, are removed.

In other embodiments, after the continuous active area is formed in the substrate, a second mask layer as shown in FIG. 7 may be further formed on the substrate. The first pattern in the second mask layer includes peripheral first patterns 401b and central first patterns 401a. The size of the peripheral first pattern 401b is greater than that of the central first pattern 401a, such that the size of the outermost division trench formed in the substrate is greater than that of the division trenches in other positions.

A third pattern may also be formed in the second mask layer 200. When the division trench is formed, the peripheral area of the substrate is etched to form, in the peripheral area, a peripheral trench encircling the array area. A sidewall of the peripheral trench facing toward a side of the array area may be a curved surface to reduce the stress effects and improve the stability.

Finally, an insulating material is filled in the division trench and the peripheral trench to form a shallow trench isolation structure.

In the process of forming the memory in this embodiment, the substrate is etched once every time a mask layer is formed, and a discrete active area array is formed by etching the substrate several times.

An embodiment of the present disclosure also provides a memory formed in the above embodiments.

With reference to FIG. 5, a schematic structural diagram of a memory according to an embodiment of the present disclosure is illustrated.

The memory includes a substrate 100, including an array area 101 and a peripheral area 102 encircling the array area 101. a plurality of discrete active areas 501 arranged in an array are formed in the array area 101. The discrete active areas 501 are isolated by shallow trench isolation structures 512, 513, and 511. The shallow trench isolation structures 512 and 513 divide the continuous active area into separated discrete active areas 501, and thus the trenches can be formed by carrying out the same etching process once. The shallow trench isolation structure 511 isolates different continuous active areas.

A peripheral shallow trench isolation structure 514 is formed in the peripheral area 102 of the substrate 100, and the peripheral shallow trench isolation structure 514 encircles the array area 101. Between the peripheral shallow trench isolation structure 514 and the array area 101 there is a certain spacing, which serves as an electrical isolation structure between the array area 101 of the substrate and the peripheral area 102.

In another embodiment, a sidewall of the peripheral shallow trench isolation structure 601 (referring to FIG. 6) facing toward a side of the array area 101 is a curved surface to reduce the stress effects on the discrete active area 501 at the edge of the array area 101 and to improve the stability.

The sizes of the shallow trench isolation structures 513 at the ends of a part of outermost discrete active areas 501 are greater than those of shallow trench isolation structures in other positions. The discrete active areas 501 are formed by dividing the continuous active areas, and a part of secondary active areas smaller in size than the discrete active areas may be formed at the ends of a part of continuous active areas, which is prone to a problem of collapse. The shallow trench isolation structure 513 is formed at the position of the secondary active area to remove the secondary active area. In this way, the problem of collapse of the discrete active area at the edge of the active area array may be improved.

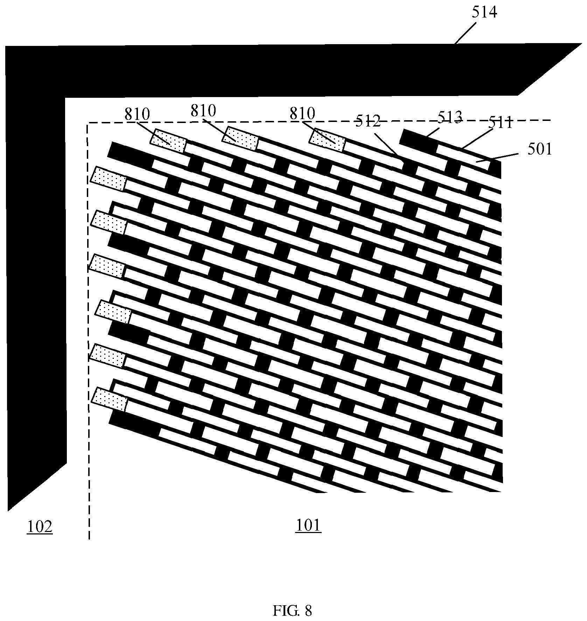

With reference to FIG. 8, in this embodiment, a shallow trench isolation structure 810 is formed at the end of a peripheral discrete active area formed after other continuous active areas without the secondary active areas are divided, and the size of the shallow trench isolation structure 810 is greater than that of the shallow trench isolation structure 512 in the array area 101. In this way, the etching load effect caused by different pattern densities can be overcome, the photoetching process window for forming the shallow trench isolation structures 512, 810 and 513 can be increased, and the accuracy of the size of the discrete active area 501 can be improved.

In FIG. 8, the sizes of the outermost shallow trench isolation structures 513 and 810 are greater than the size of the shallow trench isolation structure 512 in other positions.

In the above memory, the smaller-sized secondary active area at the edge of the discrete active area array is removed. Therefore, problems such as collapse due to the smaller-sized secondary active area present at the edge of the discrete active area array may be prevented, and thus the reliability of the memory can be improved.

Furthermore, a peripheral shallow trench isolation structure for dividing the continuous active area has a larger size, which can avoid the etching load effect in the process of forming a trench by etching. Therefore, the photoetching process window is reduced, and a patterning accuracy in the formation of the shallow trench isolation structure is enhanced, and thus performance of the memory is further improved.

What is mentioned above merely refers to some embodiments. It is to be pointed out that to those of ordinary skill in the art, various improvements and embellishments may be made without departing from the principle of the present disclosure, and these improvements and embellishments are also deemed to be within the scope of protection of the present disclosure.

## Claims

1. A formation method of a memory, comprising:
providing a substrate, the substrate comprising an array area;
forming a first mask layer on a surface of the substrate, wherein a plurality of strip-shaped patterns arranged in parallel are formed in the first mask layer to form, in the array area of the substrate, a plurality of strip-shaped continuous active areas arranged in parallel;
forming a second mask layer on the first mask layer, wherein a plurality of first patterns and a plurality of second patterns are formed in the second mask layer, the plurality of first patterns are arranged in an array and overlapped with the plurality of strip-shaped patterns to form a plurality of division trenches in the substrate to divide the continuous active areas into a plurality of discrete active areas arranged in an array, the plurality of second patterns cover ends of part of the strip-shaped patterns to remove secondary active areas positioned at ends of part of the continuous active areas, wherein the secondary active areas are formed after the continuous active areas are divided by the first patterns and are less than the discrete active areas in length; and
performing etching layer by layer into the substrate by using the first mask layer and the second mask layer as masks to transfer the strip-shaped patterns, the first patterns and the second patterns into the substrate to form a plurality of discrete active areas arranged in an array.

2. The formation method according to claim 1, wherein the plurality of strip-shaped patterns are formed by using a self-aligned double patterning (SADP) method.

3. The formation method according to claim 1, wherein the plurality of first patterns comprise central first patterns and peripheral first patterns, the peripheral first patterns being outermost first patterns, the central first patterns being positioned at inner sides of the peripheral first patterns, and a peripheral first pattern extending outward along a length direction of a strip-shaped pattern, such that a size of the peripheral first pattern is greater than that of the central first pattern.

4. The formation method according to claim 1, wherein a size of an outermost division trench is greater than sizes of the division trenches in other positions.

5. The formation method according to claim 4, wherein the substrate further comprises a peripheral area encircling the array area, wherein a third pattern positioned on the peripheral area of the substrate and encircles all the plurality of strip-shaped patterns is formed in the second mask layer, and the third pattern is configured for forming, in the peripheral area of the substrate, a peripheral trench encircling the array area.

6. The formation method according to claim 5, wherein a sidewall of the peripheral trench facing toward a side of the array area is a curved surface.

7. The formation method according to claim 5, further comprising: filling an insulating material in the division trench and the peripheral trench to form a shallow trench isolation structure.

8. A memory, comprising:
a substrate, comprising an array area; and
a plurality of discrete active areas formed in the array area and arranged in an array;
wherein the plurality of discrete active areas are isolated by shallow trench isolation structures, and sizes of at least a part of the outermost shallow trench isolation structures in length direction of the discrete active areas are greater than those of shallow trench isolation structures in other positions in the length direction of the discrete active areas.

9. The memory according to claim 8, wherein the substrate further comprises a peripheral area encircling the array area, a peripheral shallow trench isolation structure being formed in the peripheral area, the peripheral shallow trench isolation structure encircling the array area.

10. The memory according to claim 9, wherein the discrete active areas are isolated from the peripheral area by the shallow trench isolation structures.

11. The memory according to claim 9, wherein a sidewall of the peripheral shallow trench isolation structure facing toward a side of the array area is a curved surface.

12. The memory according to claim 9, wherein there is a spacing between the peripheral shallow trench isolation structure and the array area.
